# EUROPÄISCHE PATENTSCHRIFT

(11) **EP 0 446 622 B1**
(45) Veröffentlichungstag und Bekanntmachung des Hinweises auf die Patenterteilung: **09.11.1994**
(21) Anmeldenummer: 91101816.6
(22) Anmeldetag: 09.02.1991
(51) Int. Cl.: H02B 1/20

(54) **Vorrichtung zur Festlegung von elektrischen Leitungen**
Device for fixing electrical conductors
Dispositif pour fixer des conducteurs électriques

(30) Priorität: 21.02.1990 DE 4005381
(43) Veröffentlichungstag der Anmeldung: 18.09.1991
(73) Patentinhaber: kabelmetal electro GmbH, 30002 Hannover (DE); Dynamit Nobel Aktiengesellschaft, 53839 Troisdorf (DE)
(72) Erfinder: Schauer, Friedrich, W-8501 Heroldsberg (DE); Wolff, Manfred, W-8501 Schwarzenbruck (DE); Schäfer, Heinz, W-5300 Bonn (DE); Sturm, Joachim, W-5204 Lohmar 1 (DE); Voss, Thomas, W-5210 Troisdorf (DE)

(56) Entgegenhaltungen:
- DE-A- 2 515 650
- DE-A- 3 527 573

## Beschreibung

Die Erfindung bezieht sich auf eine Vorrichtung zur Festlegung von elektrischen Leitungen in einem Gehäuse eines elektrischen Geräts mit in unterschiedlichen Bereichen angeordneten elektrischen Bauteilen, die innerhalb des Geräts durch die Leitungen elektrisch leitend miteinander verbunden sind, bei welcher die Leitungen parallel und mit Abstand zueinander sowie in einer Reihe nebeneinander in einem mechanisch stabilen, aus Isoliermaterial bestehenden Formkörper festgelegt sind, der zwei im wesentlichen parallel zueinander verlaufende Seitenflächen und vier dieselben verbindende, im Verhältnis zu den Seitenflächen schmale Stirnflächen aufweist, aus dessen einer Stirnfläche die Leiter der Leitungen als metallisch blanke Stifte herausragen, die zum Anschluß eines Teils der im Gerät befindlichen Bauteile dienen, während an dem der Stirnfläche mit den Stiften abgewandten Ende des Formkörpers zumindest an einen Teil der Leitungen andere Bauteile des Geräts angeschlossen sind (DE-OS 35 27 573).

"Gerät" im Sinne der Erfindung sind alle elektrischen Geräte, die in ihrem Gehäuse eine Verdrahtung zur Verbindung von Stromverbrauchern mit einer Stromquelle und/oder untereinander aufweisen. Solche Verdrahtungen sind unter der allgemeinen Bezeichnung "Kabelbaum" für alle möglichen elektrischen Geräte, wie Waschmaschinen, Geschirrspüler oder auch Kraftfahrzeuge, bekanntgeworden.

In solchen Kabelbäumen ist eine Anzahl von elektrischen Leitungen unterschiedlicher Länge zu einer Einheit zusammengefaßt. Die Montage wird dadurch erleichtert, da nur noch das eine Bauteil "Kabelbaum" im Gehäuse eines Gerätes befestigt werden muß. Die Kabelbäume haben sich bewährt. Sie sind auch gut brauchbar, solange alle miteinander zu verbindenden Teile in einem abgeschlossenen, ungeteilten Gerät untergebracht sind und einzeln an die Leitungen des Kabelbaumes angeschlossen werden können.

Bei Geräten, deren Gehäuse aus zwei oder mehr Teilen bestehen, reicht ein solcher Kabelbaum meistens nicht aus. Das gilt auch dann, wenn ein Teil der elektrischen Bauteile bereits mittels einer gedruckten Schaltung zu einer elektrischen Einheit verbunden bzw. auf einer entsprechend festen gedruckten Schaltung angeordnet ist. In beiden Fällen kann der Kabelbaum nur zum elektrischen Verbinden eines Teiles der elektrischen Bauteile verwendet werden. Zum anderen Teil der elektrischen Bauteile muß eine zusätzliche Verbindung geschaffen werden. Weitere Schwierigkeiten ergeben sich dann, wenn neben der internen Verdrahtung elektrische Leitungen auch aus dem Gerät herausgeführt sind. Diese Leitungen und ihre Festlegung im Gerät erfordern zusätzlichen Aufwand für die Montage, die elektrische Verbindung und gegebenenfalls auch für eine feuchtigkeitsdichte Einführung in das Gehäuse des Geräts.

Bei der Vorrichtung nach der eingangs erwähnten DE-OS 35 27 573 sind die Leitungen feuchtigkeitsdicht in dem Formkörper untergebracht, der einfach am Gehäuse des Geräts montiert werden kann. Die Position der aus dem Formkörper herausragenden Stifte liegt dann fest. Das bringt keine Probleme, solange einzelne Leiter oder auch flexible Leitergruppen an die Stifte angeschlossen werden sollen. Wenn zum Anschluß der Bauteile aber beispielsweise eine gedruckte Schaltung oder ein anderes Gebilde mit elektrischen Leitern an die Stifte anzuschließen ist, bei denen die Anschlußstellen für die Stifte festliegen und die im Gehäuse eine ganz bestimmte Position einnehmen müssen, kann es Schwierigkeiten geben, wenn die Stifte nicht genau am vorgegebenen Ort angebracht sind bzw. nicht innerhalb des Toleranzbereiches liegen.

Der Erfindung liegt die Aufgabe zugrunde, eine Vorrichtung der eingangs beschriebenen Art so weiterzubilden, daß ein problemloser Anschluß der Bauteile an die aus dem Formkörper herausragenden Stifte möglich ist, und zwar unabhängig von der Ausführung des zur elektrischen Verbindung eingesetzten Gebildes.

Diese Aufgabe wird gemäß der Erfindung dadurch gelöst, daß der Formkörper in einem fest im Gehäuse montierten Rahmen angeordnet ist, dessen lichte Abmessungen in Richtung einer Verlängerung der Seitenflächen des Formkörpers größer als dessen Abmessungen sind, so daß der Formkörper in dem an beiden Seitenflächen desselben anliegenden Rahmen beweglich geführt ist.

Die Leitungen, an welche ein Teil der elektrischen Bauteile des Gerätes angeschlossen ist, sind in dem Formkörper so festgelegt, daß sie nach Einbau des Rahmens mit dem Formkörper in das Gehäuse des Gerätes grundsätzlich lagerrichtig in demselben angeordnet sind. Die aus dem Formkörper herausragenden Stifte stehen dann für die Kontaktierung mit den Bauteilen des Gerätes, welche nicht an die Leitungen angeschlossen sind, direkt zur Verfügung. Die Herstellung einer elektrisch leitenden Verbindung mit den Stiften ist dann besonders einfach, wenn das Verbindungselement zu den Bauteilen zu einer Einheit mit mehreren Kontaktstellen zusammengefaßt ist. Zweckmäßig ist die Einheit als Schaltkarte mit gedruckter Schaltung ausgebildet, auf welcher die Bauteile auch direkt angeordnet sein können. Eine solche Einheit, insbesondere eine Schaltkarte, hat in dem Gehäuse des Geräts eine genau festgelegte Position. Das gilt dann auch für die beispielsweise als Lötösen ausgebildeten Kontaktstelle zur Verbindung mit den Stiften des Formkörpers. Durch die bewegliche Anordnung des Formkörpers in dem Rahmen können eventuelle Ungenauigkeiten beim Einbau des Rahmens auf einfache Weise ausgeglichen werden, da der Formkörper, wenn auch in engen Grenzen, leicht in eine Position gebracht werden kann, in der die Kontaktstellen des Verbindungselements mit den Stiften verbunden werden können.

Ein Ausführungsbeispiel des Erfindungsgegenstandes ist in den Zeichnungen dargestellt.

Es zeigen:
Fig. 1 in schematischer Darstellung ein aus zwei Teilen bestehendes Gehäuse eines elektrischen Geräts.
Fig. 2 ein Teil dieses Geräts in vergrößerter Darstellung teilweise im Schnitt mit einer perspektivischen Darstellung eines Formkörpers.
Fig. 3 eine Ansicht des Formkörpers aus Fig. 2 in Richtung des Pfeiles A.
Fig. 4 eine Draufsicht auf den Formkörper nach Fig. 3.
Fig. 5 die Vorrichtung nach der Erfindung in vergrößerter Darstellung.
Fig. 6 einen Schnitt durch die Vorrichtung nach Fig. 5.
Fig. 7 eine Seitenansicht der Vorrichtung nach Fig. 5.

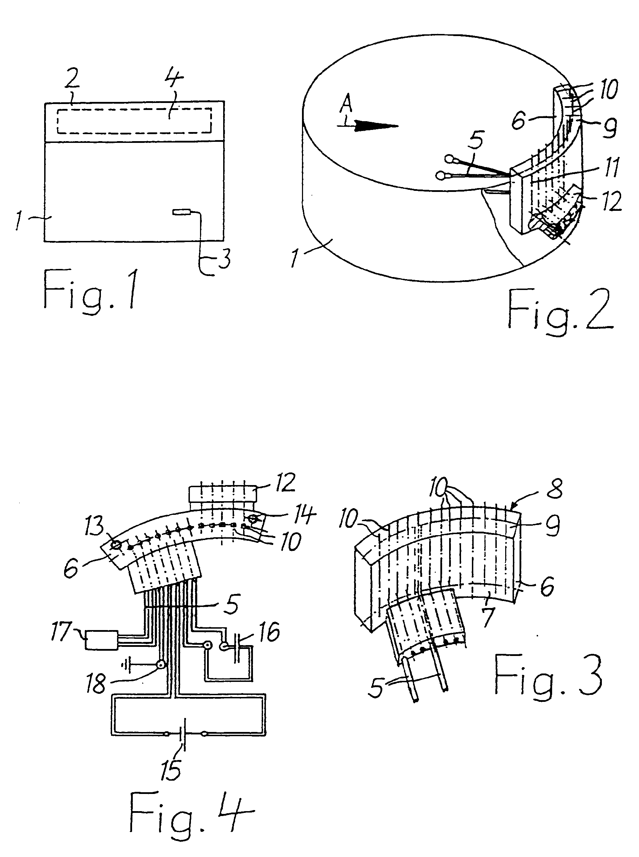

Das in Fig. 1 schematisch angedeutete elektrische Gerät hat ein Gehäuse, das aus den Gehäuseteilen 1 und 2 besteht, die getrennt bestückt und in der Endmontage miteinander verbunden sein können. Bei dem Gehäuseteil 2 kann es sich beispielsweise um einen Deckel handeln, mit dem der in der Darstellung untere Gehäuseteil 1 verschlossen werden kann. An den Gehäuseteil 1 kann eine elektrische Leitung 3 angeschlossen sein. Es können in beiden Gehäuseteilen 1 und 2 elektrische Bauteile vorhanden sein, die getrennt voneinander zu verdrahten sind. Die Bauteile können aber auch alle im Gehäuseteil 1 angeordnet sein, wobei ein Teil derselben beispielsweise auf einer Schaltkarte mit gedruckter Schaltung angeordnet und zu einer in Fig. 1 gestrichelt angedeuteten Einheit 4 zusammengefaßt sein kann. Die Einheit 4 kann mehrere, der Anzahl der Bauteile entsprechende Kontaktstellen haben, die bei einer Schaltkarte beispielsweise als Lötösen ausgebildet sein können. Wie die Einheit 4 von Bauteilen aussieht, ist für die vorliegende Vorrichtung nicht von großer Bedeutung. Sie ist vorzugsweise durch eine Schaltkarte realisiert. Die Bauteile müssen nicht zu einer Einheit 4 zusammengefaßt sein, sondern sie können auch einzeln oder in Gruppen weiterverbunden werden.

Für die Verdrahtung der im Gehäuseteil 1 angeordneten elektrischen Bauteile, bei denen es sich auch um eine Stromquelle handeln kann, wird eine geeignete Anzahl von elektrischen Leitungen 5 verwendet, die in einem mechanisch stabilen, aus Isoliermaterial bestehenden Formkörper 6 angeordnet sind. Im dargestellten Ausführungsbeispiel ist der Formkörper 6 gebogen ausgeführt, weil das Gehäuse 1,2 rund ist. Er hat zwei große, im wesentlichen parallel zueinander verlaufende Seitenflächen 7 und 8 und vier dieselben verbindende Stirnflächen, die im Verhältnis zu den Seitenflächen 7 und 8 schmal sind.

Die Leitungen 5 sind an einem Ende in den Formkörper 6 hineingeführt. Sie enden im dargestellten Fall in der Stirnfläche 9 des Formkörpers 6, welche dem aufzusetzenden Gehäuseteil 2 zugewandt ist. Die Enden der Leiter der Leitungen 5 sind abisoliert und ragen als Stifte 10 aus der Stirnfläche 9 des Formkörpers 6 heraus. Zweckmäßigerweise werden als Leiter für die Leitungen 5 Rundleiter verwendet, die eine ausreichende Stabilität aufweisen, damit sie als Stifte verwendet werden können. Die Stifte 10 dienen vorzugsweise als sogenannte Lötstifte, welche mit entsprechenden Lötösen oder anderen Gegenkontakten elektrisch leitend verbunden, vorzugsweise verlötet, werden können.

Neben den Leitungen 5 kann im Formkörper 6 eine Anzahl elektrischer Leiter 11 festgelegt sein, die ebenfalls aus der Stirnfläche 9 des Formkörpers 6 als Stifte 10 herausragen. Die Leiter 11 sind im Formkörper 6 so geführt, daß sie mit ihren anderen Enden in einer seitwärts abstehenden Erweiterung 12 desselben liegen. An diesen Enden können Steckkontakte angebracht sein, die in der Erweiterung 12 angeordnet und so von außen zugänglich sind. Neben der inneren Verdrahtung und Stromversorgung eines Geräts ist es auf diese Weise möglich, eine Leitung 3 an das Gerät anzuschließen, mit der beispielsweise elektrische Impulse oder Steuerbefehle in das Gerät eingegeben werden können.

Zur Sicherung für ein richtiges Anschließen der elektrischen Bauteile des Geräts an die Stifte 10 ist es möglich, zusätzliche Führungselemente vorzusehen. Solche Führungselemente können besonders dann erforderlich sein, wenn der Formkörper 6 nicht gebogen, sondern geradlinig verlaufend ausgeführt ist. In bevorzugter Ausführungsform können am Formkörper 6 Führungsstifte 13 und 14 (Fig. 4) angebracht sein, die bei Montage der zu der Einheit 4 zusammengefaßten anderen Bauteile in korrespondierende Führungslöcher derselben eingreifen.

Im dargestellten Ausführungsbeispiel sind im Formkörper 6 sieben Leitungen 5 und fünf Leiter 11 festgelegt. Während die Leiter 11 zum Anschluß einer von außen herangeführten Leitung 3 dienen, sind an die Leitungen 5 elektrische Bauteile des zu verdrahtenden Geräts angeschlossen. Bei diesen Bauteilen handelt es sich beispielsweise um eine Batterie 15 als Stromquelle, einen Kondensator 16 und einen Sensor 17. Eine der Leitungen 5 kann an der Stelle 18 auch an Masse angeschlossen sein.

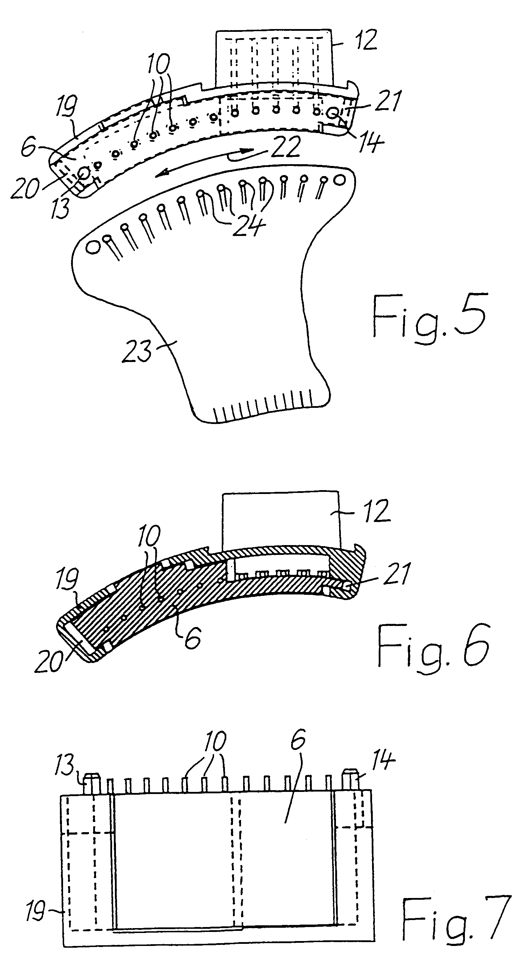

Der in den Fig. 2 bis 4 nur prinzipiell dargestellte Formkörper 6 ist gemäß der genaueren Darstellung in den Fig. 5 bis 7 in einem Rahmen 19 angeordnet, der fest in dem Gehäuse des elektrischen Geräts montiert wird. Rahmen 19 und Formkörper 6 sind in ihrer Formgebung der Kontur des Gehäuses angepaßt. Im vorliegenden Fall sind sie bei einem runden Gehäuse gebogen ausgeführt. Der Rahmen 19 hat gegenüber dem Formkörper 6 in einer Richtung eine größere lichte Abmessung, und zwar in einer Verlängerung der beiden Seitenwände 7 und 8 des Formkörpers 6. Es ergeben sich entsprechend der Darstellung in den Fig. 5 und 6 dann beispielsweise auf zwei Seiten des Formkörpers 6 Spalte 20 und 21 innerhalb des Rahmens 19. Wenn der Formkörper 6 auf einer Seite am Rahmen 19 anliegt, besteht nur auf der gegenüberliegenden Seite ein entsprechend vergrößerter Spalt. Die aus dem Formkörper 6 herausragenden Stifte 10 sowie Führungsstifte 13 und 14 sind aus Fig. 7 deutlich zu ersehen.

Der Formkörper 6 kann innerhalb des Rahmens 19 um eine der gemeinsamen Breite der beiden Spalte 20 und 21 entsprechende Strecke bewegt werden, und zwar nur in Richtung einer Verlängerung seiner Seitenflächen 7 und 8 bzw. in der durch den Doppelpfeil 22 angedeuteten Richtung. Eine in Fig. 5 schematisch angedeutete elektronische Schaltung 23, bei der es sich um eine Schaltkarte handeln kann und die innerhalb eines Geräts eine feste Position einnehmen muß, kann mit ihren Lötösen 24 leicht an die Stifte 10 angeschlossen werden, auch wenn der Rahmen 19 nicht ganz genau in der gewünschten Position montiert ist. Es ist nur erforderlich, daß der Abstand der Stifte 10 voneinander dem Abstand der Lötösen 24 voneinander entspricht. Die richtige Position des Formkörpers 6 durch Verschiebung desselben in Richtung des Doppelpfeiles 22 ist insbesondere durch die Führungsstifte 13 und 14 leicht einstellbar. Der Formkörper 6 ist trotz seiner Beweglichkeit im Rahmen 19 einwandfrei geführt, da der Rahmen 19 an den Seitenflächen 7 und 8 des Formkörpers 6 anliegt, so daß derselbe nicht ausweichen kann.

## Patentansprüche

1. Vorrichtung zur Festlegung von elektrischen Leitungen in einem Gehäuse eines elektrischen Geräts mit in unterschiedlichen Bereichen angeordneten elektrischen Bauteilen, die innerhalb des Geräts durch die Leitungen (5) elektrisch leitend miteinander verbunden sind, bei welcher die Leitungen (5) parallel und mit Abstand zueinander sowie in einer Reihe nebeneinander in einem mechanisch stabilen, aus Isoliermaterial bestehenden Formkörper (6) festgelegt sind, der zwei im wesentlichen parallel zueinander verlaufende Seitenflächen (7, 8) und vier dieselben verbindende, im Verhältnis zu den Seitenflächen schmale Stirnflächen aufweist, aus dessen einer Stirnfläche (9) die Leiter der Leitungen als metallisch blanke Stifte (10) herausragen, die zum Anschluß eines Teils der im Gerät befindlichen Bauteile dienen, während an dem der Stirnfläche mit den Stiften (10) abgewandten Ende des Formkörpers (6) zumindest an einen Teil der Leitungen andere Bauteile des Geräts angeschlossen sind, dadurch gekennzeichnet, daß der Formkörper (6) in einem fest im Gehäuse montierten Rahmen (19) angeordnet ist, dessen lichte Abmessungen in Richtung einer Verlängerung der Seitenflächen (7,8) des Formkörpers (6) größer als dessen Abmessungen sind, so daß der Formkörper (6) in dem an beiden Seitenflächen (7,8) desselben anliegenden Rahmen (19) beweglich geführt ist.

2. Vorrichtung nach Anspruch 1, dadurch gekennzeichnet, daß der Formkörper (6) und damit auch der Rahmen (19) entsprechend der Krümmung des Gehäuses gebogen ausgeführt sind.

## Claims

1. Device for fixing electrical cables in a housing of an electrical apparatus having electrical components which are arranged in different regions and are electrically conductively connected to one another within the apparatus by means of the cables (5), in the case of which device the cables (5) are fixed parallel and at a distance from one another, as well as in a row side by side in a mechanically robust moulding (6) which consists of insulating material and has two side surfaces (7, 8), which run essentially parallel to one another, and four end surfaces which connect said side surfaces (7, 8) and are narrow in comparison with the side surfaces, and from whose one end surface (9) the conductors of the cables project as metallically bare pins (10) which are used for connecting some of the components located in the apparatus, while other components of the apparatus are connected to at least some of the cables at that end of the moulding (6) which faces away from the end surface with the pins (10), characterized in that the moulding (6) is arranged in a rack (19) which is mounted firmly in the housing and whose unobstructed dimensions in the direction of an extension of the side surfaces (7, 8) of the moulding (6) are larger than the dimensions of the latter, so that the moulding (6) is guided such that it can move in the rack (19) which rests against the two side surfaces (7, 8) of said moulding (6).

2. Device according to Claim 1, characterized in that the moulding (6), and hence also the rack (19), are designed curved to match the curvature of the housing.

## Revendications

1. Dispositif de fixation de conducteurs électriques dans un boîtier d'un appareil électrique comportant des composants électriques qui sont disposés dans différentes zones et qui, à l'intérieur de l'appareil, sont électriquement reliés les uns aux autres par les conducteurs (5), dispositif dans le cas duquel les conducteurs (5) sont fixés, parallèlement les uns aux autres et à distance les uns des autres, ainsi que, dans une rangée, l'un à côté de l'autre, dans une pièce de forme qui est mécaniquement stable, est constituée d'un matériau isolant et présente deux surfaces latérales (7, 8) orientées sensiblement parallèlement l'une à l'autre et quatre surfaces frontales, étroites par rapport aux surfaces latérales et les reliant, dispositif de l'une des surfaces frontales (9) duquel les fils électriques des conducteurs dépassent sous forme de broches métalliques dénudées (10) qui servent à raccorder une partie des composants se trouvant dans l'appareil, tandis qu'à l'extrémité de la pièce de forme (6) opposée à la surface frontale présentant les broches (10) sont raccordés, au moins à une partie des conducteurs, d'autres composants de l'appareil, dispositif caractérisé par le fait que la pièce de forme (6) est disposée dans un cadre (19) qui est monté de façon fixe dans le boîtier et dont les dimensions de l'ouverture libre sont, dans le sens du prolongement des surfaces latérales (7, 8) de la pièce de forme (6), supérieures à celles de cette dernière, de sorte que la pièce de forme (6) est guidée, avec possibilité de mobilité, dans le cadre (19) qui s'appuie contre ses deux surfaces latérales (7, 8).

2. Dispositif selon la revendication 1, caractérisé par le fait que la pièce de forme (6) et donc également le cadre (19) sont réalisés cintrés, en correspondance avec le cintrage du boîtier.
